# EUROPÄISCHE PATENTSCHRIFT

(11) **EP 4 453 270 B1**
(45) Veröffentlichungstag und Bekanntmachung des Hinweises auf die Patenterteilung: **21.01.2026**
(21) Anmeldenummer: 22800075.8
(22) Anmeldetag: 24.10.2022
(51) Int. Cl.: C23C 16/54, C23C 14/56, H01L 21/67, H01L 21/677

(54) **INLINE-ANLAGE ZUM BESCHICHTEN VON EINZELNEN ODER VON GRUPPEN VON SUBSTRATEN UND VERFAHREN ZUM BESCHICHTEN EINZELNER SUBSTRATE ODER SUBSTRATGRUPPEN IN EINER INLINE-BESCHICHTUNGSANLAGE**
IN-LINE SYSTEM FOR COATING INDIVIDUAL OR GROUPS OF SUBSTRATES AND METHOD FOR COATING INDIVIDUAL SUBSTRATES OR SUBSTRATE GROUPS IN AN IN-LINE COATING SYSTEM
SYSTÈME EN LIGNE DE REVÊTEMENT DE SUBSTRATS INDIVIDUELS OU DE GROUPES DE SUBSTRATS ET PROCÉDÉ DE REVÊTEMENT DE SUBSTRATS INDIVIDUELS OU DE GROUPES DE SUBSTRATS DANS UN SYSTÈME DE REVÊTEMENT EN LIGNE

(30) Priorität: 22.12.2021 DE 102021134254
(43) Veröffentlichungstag der Anmeldung: 30.10.2024
(73) Patentinhaber: Cremer, Rainer, 52156 Monschau (DE)
(72) Erfinder: Cremer, Rainer, 52156 Monschau (DE)
(74) Vertreter: RGTH
(86) Internationale Anmeldenummer: PCT/DE2022/100778
(87) Internationale Veröffentlichungsnummer: WO 2023/116961

(56) Entgegenhaltungen:
- EP-A2- 0 210 578
- WO-A1-2011/121665
- DE-A1- 4 111 384

## Beschreibung

Die Erfindung betrifft eine Inline-Anlage zum Beschichten von einzelnen oder von Gruppen von Substraten, die mehrere hintereinander angeordnete, über Pumpen evakuierbare Kammern aufweist, nämlich eine Einschleusekammer, eine Wartekammer, mindestens eine Prozesskammer, eine weitere Wartekammer und eine Ausschleusekammer, die von den Substraten oder Substratgruppen nacheinander durchlaufen werden und die durch Ventile jeweils verschließbar sind.

Die Erfindung betrifft ferner ein Verfahren zum Beschichten einzelner Substrate oder Substratgruppen in einer solchen Inline-Beschichtungsanlage.

Aus der WO 2011/121665 A1 ist eine Vorrichtung zur Herstellung eines elektronischen Bauelements, die ein In-Line-System verwendet, bekannt, wobei Partikel daran gehindert werden, aus einer Filmbildungskammer in eine Prozesskammer des nachfolgenden Schritts zu fließen. Eine Pufferkammer ist zwischen der Filmbildungskammer und der Prozesskammer des nachfolgenden Schritts angeordnet, mit dazwischen vorhandenen Schieberventilen, und die in der Filmbildungskammer erzeugten Partikel werden in der Pufferkammer durch Ablassen von Luft durch unabhängiges Öffnen/Schließen der Schieberventile vor und hinter der Pufferkammer entfernt.

Die DE 41 11 384 A1 offenbart ein Verfahren und eine Vorrichtung zur Beschichtung von Substraten vorzugsweise mittels Kathodenzerstäubung in einer Vakuumanlage, bestehend aus mindestens einer Zerstäubungskammer, in der verschiedenartige Schichtsysteme auf die zu beschichtenden vorzugsweise gebogenen Substrate aufbringbar sind, die Substrate in einer Bewegungsrichtung durch die Vakuumanlage hindurch bewegbar sind und die Zerstäubungskammer in Bewegungsrichtung sowie in entgegengesetzter Richtung mehrfach im sogenannten Multipass-Mode durchlaufen, wobei die zu beschichtenden Substrate vor dem Eintritt in die Zerstäubungskammer in Gruppen von mehreren, vorzugsweise von je zwei Substraten bzw. die die Substrate aufnehmenden Carrier zusammengefasst sind und diese die Zerstäubungskammer gleichzeitig im sogenannten Dual-Multipass-Mode durchlaufen.

Die EP 0 210 578 A2 offenbart ein System und ein Verfahren zum Aufbringen eines elektrischen Isolators auf ein Substrat. Das System umfasst eine erste, eine zweite und eine dritte Kammer, wobei die zweite Kammer eine Abscheidekammer zum Aufbringen des Isolators auf das Substrat ist. Eine Vielzahl von Gasschleusen verbindet die zweite Kammer mit der ersten Kammer und die zweite Kammer mit der dritten Kammer in Reihe. Ein Endlosförderer in jeder der Kammern transportiert das Substrat nacheinander durch die Kammern. Mehrere Pumpen zur Regelung des absoluten Drucks sorgen für einen unidirektionalen Gasstrom von der ersten und dritten Kammer in die zweite Kammer, um einen gewünschten Isolationsgrad aufrechtzuerhalten, der als Konzentrationsverhältnis der Gasbestandteile zwischen den Kammern ausgedrückt werden kann.

Werkstückbeschichtungen werden beispielsweise eingesetzt, um die Verschleißfestigkeit und die Standzeit von Bauteilen zu erhöhen. Vielfach dienen Werkzeugbeschichtungen auch als Korrosionsschutz oder zur Verbesserung von physikalischen Eigenschaften. Die hier angesprochenen Verfahren sind die chemische Dampfabscheidung (CVD) oder die physikalische Dampfabscheidung (PVD), die gegenüber der CVD den Vorteil einer deutlich niedrigeren Abscheidetemperatur besitzt. Neben den chargenbetriebenen Verfahren in sog. Batch-Anlagen, in denen eine große Anzahl von Werkstücken in einem Beschichtungsgefäß während des Beschichtens feststehend angeordnet ist, werden Beschichtungen auch in einem kontinuierlichen Prozess vorgenommen, bei dem die Substrate in Durchlaufanlagen nacheinander verschiedene Stationen durchlaufen. Diese Stationen werden durch verschiedene Kammern einer Inline-Anlage realisiert, in denen das für die Durchführung von CVD- oder PVD-Prozessen notwendige Vakuum erzeugt, die Werkstückoberflächen geätzt und beschichtet werden, ggf. durch zwei Lagen, die nacheinander aufgetragen werden. Bei sehr dünnen Schichten wie z.B. bei optischen Schichten oder Beschichtungen für Batterien und Brennstoffzellen wird die Evakuierungs- und Belüftungszeit zum geschwindigkeitsbestimmenden Schritt, durch den die Produktivität der Anlage definiert wird. Beispielsweise werden für das Oberflächenätzen sowie das Beschichten jeweils ca. 1 min benötigt, wohingegen das Be- und Entladen ggf. in weniger als 1 min per Roboter erfolgen kann. Aufgrund technischer Limitierungen kann in derart kurzen Zeiten kein Ein- bzw. Ausschleusevorgang erfolgen. Die technisch machbare Grenze für diese Vorgänge scheint bei etwa 2 min zu liegen.

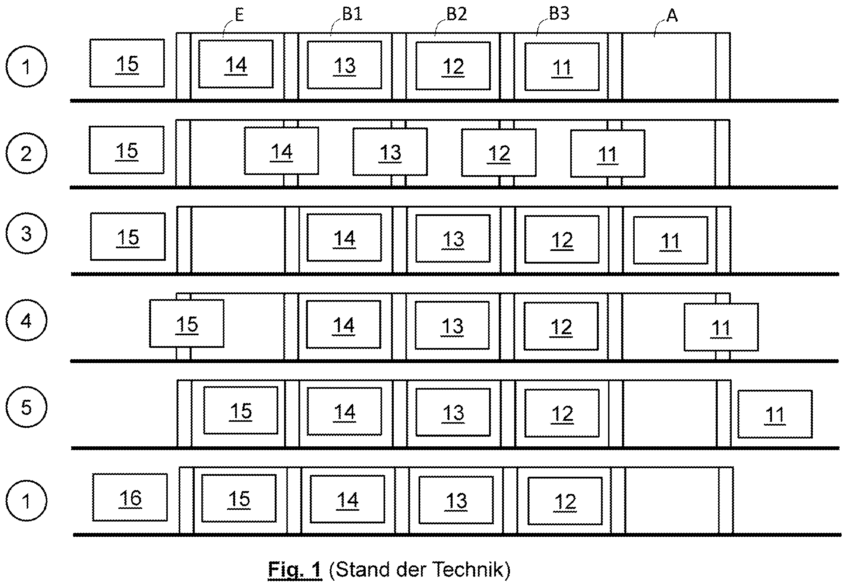

In Fig. 1 ist ein aus fünf Kammern bestehende, nach dem Stand der Technik bekannte Anlage skizziert, die aus einem Beladebereich, einer Einschleusekammer, einer Ätzkammer, zwei aufeinanderfolgenden Beschichtungskammern, einer Ausschleusekammer und einem Entladebereich besteht. Die genannten Kammern sind jeweils mit Pumpen versehen und mit Ventilen verbunden, so dass Sie wahlweise und unabhängig voneinander be- und entlüftet werden können.

In Fig. 1 sind fünf unterschiedliche Beladezustände skizziert, die mit Zeilennummern 1, 2, 3, 4 und 5 benannt sind. Die Werkstücke tragen die Bezugszeichen 11, 12, 13, 14 und 15. Die Beschichtungskammern sind so ausgebildet, dass jeweils eines der Werkstücke 11 bis 15 aufgenommen werden kann. Das Werkstück 15 befindet sich im sog. Beladebereich, wohingegen in der Einschleusekammer das Werkstück 14 temporär gelagert wird, bis der erforderliche Vakuum-Druck erreicht ist. Gleichzeitig wird das Werkstück 13 in einer Ätzkammer geätzt sowie das Werkstück 12 in einer ersten Beschichtungskammer mit einer ersten Beschichtung und das Werkstück 11 in einer zweiten Beschichtungskammer mit einer zweiten Beschichtung (als Außenschicht auf die erste Beschichtung) versehen.

Konkret betragen die Evakuierungs- und Belüftungszeiten der Anlage jeweils 2 min. In dem zweiten Schritt (zweite Zeile) werden die Werkstücke 11, 12, 13 und 14 nach Öffnen der entsprechenden Ventile jeweils in die nächste Kammer geschoben, nämlich das Werkstück 14 in die Ätzkammer, das Werkstück 13 in die erste Beschichtungskammer und das Werkstück 12 in die zweite Beschichtungskammer sowie das Werkstück 11 in die Ausschleusekammer. Das Ende dieses Transfers ist in der dritten Zeile dargestellt. Hiernach wird die Einschleusekammer zum Einführen des Werkstückes 15 geöffnet und gleichzeitig das Werkstück 11 aus der Ausschleusekammer nach Belüften herausgeführt, was in der vierten Zeile dargestellt ist.

Sobald das Werkstück 15 in der Einschleusekammer positioniert ist und das Werkstück 11 aus der Ausschleusekammer in den Entladebereich transportiert ist, werden die Ventile der Einschleusekammer sowie der Ausschleusekammer wieder geschlossen, wonach die Einschleusekammer evakuiert wird. Gleichzeitig ist die Oberflächenätzung die erste Beschichtung und die zweite Beschichtung der jeweiligen Werkstücke, die sich in den betreffenden Kammern befinden, abgeschlossen. In der letzten Zeile, die ebenfalls mit der "Ziffer 1" versehen ist, ist die Bereitstellung eines weiteren Werkstücks 16 angedeutet.

Der vorstehend geschilderte Durchlaufprozess hat eine Taktzeit, die durch die Evakuierungszeit von 2 min vorgegeben wird.

Es ist Aufgabe der vorliegenden Erfindung eine Inline-Anlage der eingangs genannten Art bzw. ein Verfahren der eingangs genannten Art so zu verbessern, dass eine höhere Produktivität erreicht wird.

Diese Aufgabe wird durch eine Inline-Anlage nach Anspruch 1 bzw. durch ein Verfahren nach Anspruch 5 gelöst.

Erfindungsgemäß werden die Einschleuse- und die Ausschleusekammer jeweils vergrößert, so dass sie eine Durchlauflänge zur gleichzeitigen Aufnahme von n hintereinander oder nebeneinander angeordneten Substraten oder Substratgruppen besitzen, wobei n eine natürliche Zahl ist. Die zwischen der Einschleusekammer und der Prozesskammer sowie zwischen der Ausschleusekammer und der Prozesskammer angeordnete Wartekammer hat eine Kapazität zur Aufnahme von (n-1) Substraten oder Substratgruppen, wohingegen die Kapazität der Behandlungskammern jeweils auf die Aufnahme von einem Substrat beschränkt ist. Die Einschleuse- und die Ausschleusekammern sind vorzugsweise n-mal so lang wie die Behandlungskammern, nämlich der gleichlangen Kammern zum Ätzen und zum Beschichten, während die Wartekammern n-1 mal so lang wie die Behandlungskammern sind. Hierdurch wird erreicht, dass in der Entlüftungskammer gleichzeitig für n Substrate oder Substratgruppen ein für die Prozessdurchführung notwendiges Vakuum hergestellt wird. Der zeitintensivste Vorgang des Ent- und Belüften "verteilt" sich somit auf n Substrate bzw. n Substratgruppen, so dass die zeitintensivsten Schritte der beiden äußeren Kammern (zum Be- und Entlüften) nur noch in jedem n-ten Takt durchgeführt werden müssen und die Taktzeit der anderen Kammern, die wesentlich kürzer ist, erhalten bleiben kann. Die Vergrößerung der beiden äußeren Kammern (nämlich der Einschleuse- und der Ausschleusekammer) sowie die Einfügung jeweiliger Wartekammern führt zwar zu einer Steigerung der Anlagekosten, jedoch steht dem die n-fache Vergrößerung der Produktivität der Anlage entgegen. In jedem Fall sind die zusätzlichen Anlagekosten deutlich geringer als die Aufstellung mehrerer Fertigungsstraßen, um dieselben Taktverhältnisse zu ermöglichen.

Vorzugsweise besitzt die Inline-Anlage als erste Prozesskammer eine Ätzkammer sowie mindestens eine Beschichtungskammer, vorzugsweise zwei Beschichtungskammern für die Abscheidung aufeinanderfolgender Schichten. Nach einer weiteren Ausgestaltung der Erfindung weisen die Beschichtungskammern eine PVD-Einrichtung auf.

Verfahrenstechnisch wird die Aufgabe dadurch gelöst, dass zwischen jeweiligen Ätz- und/oder Beschichtungsbehandlungen die Substrate oder Substratgruppen im Verbund von der Einschleusekammer über die Wartekammer in die Behandlungskammer und eine weitere Wartekammer in die Ausschleusekammer so bewegt und so behandelt werden, dass in aufeinanderfolgenden Schritten die Einschleusekammer mit n Substraten oder n Substratgruppen und jede der Behandlungskammer mit jeweils nur einem Substrat oder einer Substratgruppe belegt sind und die Wartekammern frei von Substraten oder Substratgruppen sind. In einem nächsten Schritt, der sich anschließt, werden die Substrate oder Substratgruppen im Verbund vorwärtsbewegt, so dass nach Abschluss dieses Schrittes ein aus jeder Behandlungskammer ausgeschleustes Substrat oder eine ausgeschleuste Substratgruppe durch ein nachgeführtes Substrat oder eine nachgeführte Substratgruppe ersetzt wird und dass nach einer Teilbelegung der Wartekammer die Belegung der Einschleusekammer mit n Substraten oder Substratgruppen vorgenommen wird, wonach sich die vorbeschriebene Abfolge der Substratbewegung und Kammerbelegung sukzessive wiederholt.

Der Kerngedanke der vorliegenden Erfindung besteht darin, dass jeweils die maximale Belegungsrate der Einschleuse- und Ausschleusekammern um den ganzzahligen Faktor n größer ist.

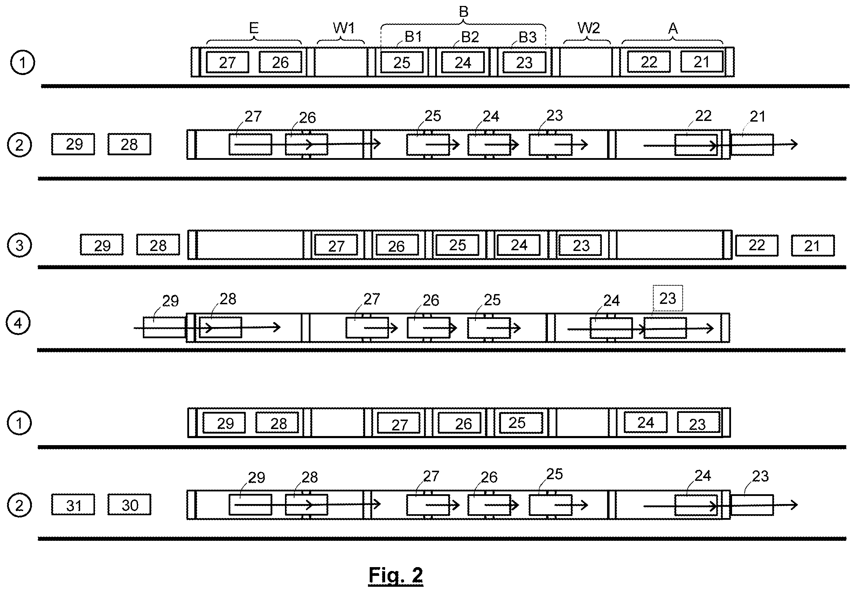

Ausführungsbeispiele der Erfindung sind in Fig. 2 bis Fig. 4 dargestellt.

In Fig. 2, Zeile 1 ist zu entnehmen, dass die Einschleusekammer E sowie die Ausschleusekammer A etwa doppelt so lang sind wie die übrigen Kammern, nämlich die beiden Wartekammern W₁, W₂ sowie die mittig angerordneten Behandlungskammern B, im vorliegenden Fall die Ätzkammer B₁, Beschichtungskammer B₂ und Beschichtungskammer B₃. In der Einschleusekammer sowie der Ausschleusekammer sind die Substrate 21, 22 sowie 26, 27 angeordnet, wohingegen sich zur selben Zeit Substrate 23, 24, 25 in der Ätzkammer, der ersten Beschichtungskammer und der zweiten Beschichtungskammer befinden. Die Wartekammern sind leer. Die Ventile zwischen den einzelnen Kammern sind geschlossen, so dass die Einschleusekammer auf den für die PVD-Behandlung notwendigen geringen Druck evakuiert werden kann. Die Ausschleusekammer wird während der Evakuierung der Einschleusekammer bereits belüftet. Gleichzeitig wird in der Ätzkammer B₁ das Substrat 25 behandelt sowie in den Beschichtungskammern B₂, B₃ die Substrate 23, 24 beschichtet. Nach Abschluss der durch die Pumpbehandlung definierten Zeit werden die Ventile zwischen der Einschleusekammer E und der ersten Wartekammer W₁ sowie von der Wartekammer W₁ zur Ätzkammer B₁ und von dort aus zu den Beschichtungskammern B₂, B₃ bis hin zur zweiten Wartekammer W₂ jeweils geöffnet. Durch Öffnen des letzten Ventils in der Ausschleusekammer A kann diese belüftet werden. Die Substrate 21, 22, 23, 24, 25, 26, 27 werden jeweils in die benachbarte Kammer (im Bild in Zeile 2 nach rechts) jeweils zwei Kammern weiter geschoben bis die in der dritten Zeile dargestellte Belegungsrate erreicht ist, in der die Einschleusekammer E sowie die Ausschleusekammer A völlig entleert sind und sich in der Ätzkammer B₁ sowie den beiden Beschichtungskammern B2, B3 jeweils ein Substrat befindet. Die Substrate 23, 27 sind in den Wartekammern angeordnet; die beiden fertig behandelten Substrate 21, 22 sind gleichzeitig ausgeschleust worden.

In der Zeile 4 wird dargestellt, wie die Einschleusekammer E mit zwei Substraten 28, 29 beladen wird und gleichzeitig das Substrat 27 in die Ätzkammer B₁ und die Substrate 25, 26 in die Kammern B₂, B₃ zur ersten bzw. zweiten Beschichtung weitergeführt werden. Das bisher in der zweiten Wartekammer W₂ angeordnete Substrat 23 wird gleichzeitig in die Ausschleusekammer A überführt, so dass sich schließlich die Anfangssituation wiedereinstellt, bei der in der Einschleusekammer E zwei Substrate 28, 29 und in den Behandlungskammern B₁ bis B₃ jeweils ein Substrat 25, 26, 27 und in der Ausschleusekammer A ebenfalls zwei Substrate 23, 24 angeordnet sind. Der Vorgang startet nunmehr erneut. Jeweils dargestellte Ventile, die z.B. als Schiebeventile ausgebildet sind, werden nur dann geöffnet, wenn ein Substrat von einer Kammer zur nächsten Kammer befördert werden soll. Die endseitigen Ventile der Einschleusekammer E und der Ausschleusekammer A werden nur zum Belüften geöffnet. Aus Fig. 2 ist ersichtlich, dass sukzessive jeweils zwei Substrate oder Substratgruppen in die Einschleusekammer E geführt werden und gleichermaßen aus der Ausschleusekammer A zwei Substrate entnommen werden. Durch die doppelte Belegung der Einschleusekammer E sowie der Ausschleusekammer A ergibt sich pro Substrat eine verringerte Evakuierungs- und Belüftungszeit, womit insgesamt die Produktrate erhöht wird.

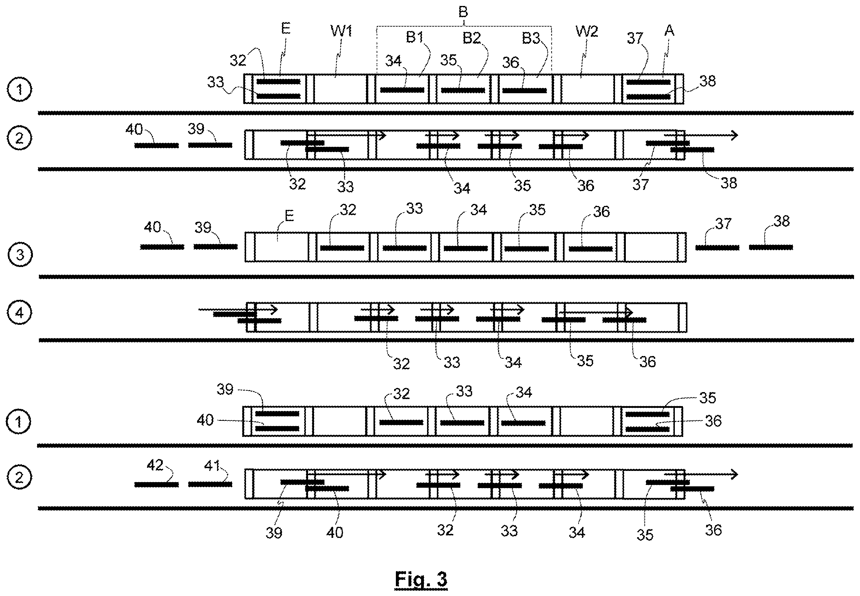

Fig.3 zeigt eine skizzierte alternative Ausführungsform einer Inline-Anlage zur gleichzeitigen Aufnahme von zwei nebeneinander angeordneten Substraten 32, 33 in der Einschleusekammer E bzw. 37, 38 in der Ausschleusekammer A. Zu Beginn des in Zeile 1 dargestellten Prozesses befinden sich jeweils einzelne Substrate 34 in der Ätzkammer B₁, 35 in der Beschichtungskammer B₂ und 36 in der Beschichtungskammer B₃. Im Gegensatz zu Fig. 2 ist zur Verdeutlichung der Nebeneinanderanordnung eine Draufsicht auf die Anlage gewählt. Zu Beginn des in Zeile 1 dargestellten Prozesses wird die Einschleusekammer E evakuiert und die Ausschleusekammer A belüftet.

Im darauffolgenden Schritt der in der zweiten Zeile dargestellt ist, werden alle genannten Substrate 32 bis 36 in die jeweils benachbarte Kammer überführt und gleichzeitig neue Substrate 39, 40 im Beladebereich bereitgestellt. Der Endzustand nach dieser Überführung ist der dritten Zeile zu entnehmen, in der gleichzeitig die Belüftung der Einschleusekammer E vorgenommen wird. Das Substrat 32 befindet 3sich zu diesem Zeitpunkt in der Wartekammer W₁, wobei das zwischen der Einschleusekammer und der Wartekammer liegende Ventil ebenso geschlossen ist wie das Ventil zwischen der Wartekammer und der Ätzkammer B₁, in der sich das Substrat 33 befindet. Die Substrate 34 und 35 werden in den Kammern B₁ und B₂ beschichtet. Das Substrat 36 verbleibt während dieser Zeit in der Wartekammer W₂, wohingegen die bereits fertig behandelten Substrate 37 und 38 bereits ausgeschleust sind. Die Ausschleusekammer A wird nach der Ausschleusung evakuiert. Sämtliche Belüftungs- und Evakuierungsvorgänge dauern ca. 1 min.

Nach erfolgter Ätz- und Beschichtungsbehandlung der Substrate 33, 34, 35 werden diese, wie in der vierten Zeile zu entnehmen ist, entsprechend in die nächstbenachbarte Kammer weitergeschoben, so dass nach Beendigung dieses Vorgangs die Substrate 39, 40 in der Einschleusekammer angeordnet sind, die Wartekammer W₁ leer ist und die Substrate 32, 33, 34 gleichzeitig in nebeneinanderliegenden Kammern B₁, B₂ und B₃ jeweils behandelt werden. Zu dieser Zeit sind die Wartekammern W₁ und W₂ entleert. Sämtliche Ventile mit Ausnahme des Endventils der Ausschleusekammer sind geschlossen. Die Ausschleusekammer, in der sich wiederum zwei nebeneinanderliegende Substrate 35, 36 befinden, wird belüftet, wonach entsprechend der Darstellung der letzten Zeile der nächste Vorgang gestartet wird. Bei dieser Kammeranordnung sind die Einschleusekammer sowie die Ausschleusekammer jeweils als Magazine ausgebildet.

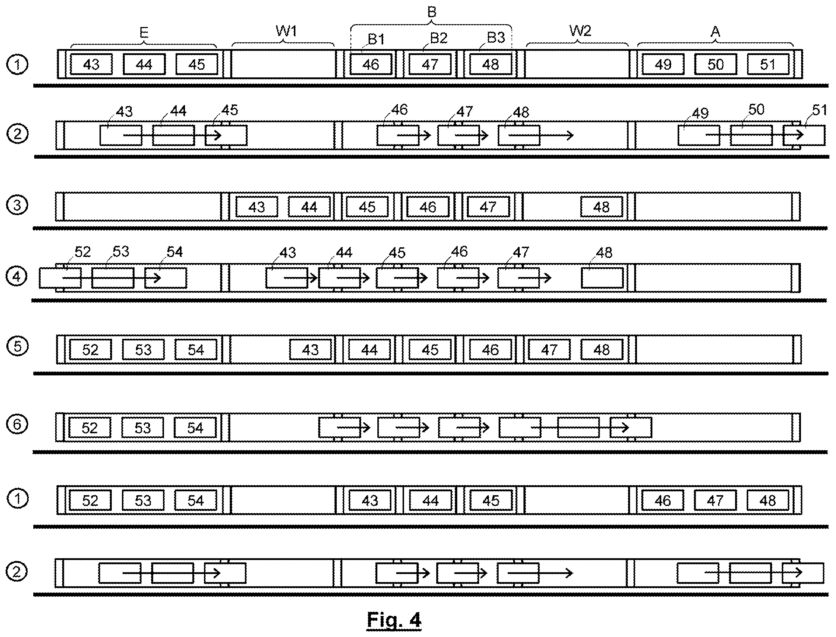

Eine weitere Verfahrens- und Inline-Anlagenvariante zeigt Fig. 4. In diesem Ausführungsbeispiel sind die Einschleusekammer und die Ausschleusekammer so dimensioniert, dass diese Kammern jeweils drei Substrate gleichzeitig aufnehmen können. Im dargestellten Beispiel sind die Substrate hintereinander angeordnet, sie können jedoch ebenso nebeneinander angeordnet sein.

Zu Beginn eines Prozesses befinden sich Substrate 43, 44, 45 in einer Einschleusekammer E, die evakuiert wird, z.B. über eine Dauer von 0,4 min. Während derselben Zeit sind die Wartekammern W₁, W₂ leer, wohingegen in der Ätzkammer B₁ ein Substrat 46 in der Beschichtungskammer B₂ ein Substrat 47 und in der zweiten Beschichtungskammer B₃ ein Substrat 48 gleichzeitig behandelt werden. In der Ausschleusekammer befinden sich drei Substrate 49, 50, 51, die nach Belüftung der Ausschleusekammer (siehe zweite Zeile) ausgeschleust werden. Zur gleichen Zeit der Ausschleusung werden die benannten Substrate weiterbewegt, bis der in der dritten Zeile dargestellte Zustand erreicht ist, bei dem in der Wartekammer zwei Substrate 43, 44 sowie in jeder der Behandlungskammern B₁, B₂, B₃ Substrate 45, 46, 47 behandelt werden. Das Substrat 48 ist in der Wartekammer angeordnet. Die Einschleusekammer wird belüftet, während dessen die Ausschleusekammer noch evakuiert wird. Nunmehr kann wie in der vierten Zeile dargestellt die Einschleusekammer mit neuen Substraten 52, 53, 54 beladen werden. Die Verschiebung der Substrate 43, 44, 45, 46 in die jeweils benachbarte Kammer bei geöffneten Ventilen ergibt sich aus Zeile 4. Nach Beladung der Einschleusekammer E wird diese Kammer (siehe fünfte Zeile) evakuiert, während sich das Substrat 43 in der Wartekammer W₁ und die Substrate 44, 45, 46 in den jeweiligen Behandlungskammern B₁, B₂, B₃ befinden, wo sie geätzt, oder mit der ersten bzw. zweiten Beschichtung versehen werden. Die Substrate 47, 48 befinden sich in der Wartekammer W₂. Die Ausschleusekammer wird evakuiert. Nach der Evakuierung und Behandlungszeit werden die Substrate 43, 44, 45, 46, 47, 48 jeweils weiterbefördert, bis eine der Anfangssituation entsprechende Anordnung erreicht wird, bei der drei Substrate 52, 53, 54 in der Einschleusekammer evakuiert werden, gleichzeitig Substrate 43, 44, 45 in den Behandlungskammer B₁, B₂, B₃, geätzt oder beschichtet und Substrate 46, 47, 48 in der Ausschleusekammer angeordnet sind, die bereits belüftet wird. Nach der Behandlungs- und Evakuierungs- bzw. Belüftungszeit von 0,4 min wird der Prozess wie in der letzten Zeile dargestellt, fortgesetzt.

Aus Figuren 2 bis 4 wird deutlich, dass die Einschleuse- und Ausschleusekammer jeweils mit n=2 oder n=3 Substraten beladen werden kann, wohingegen die Wartekammern eine Beladekapazität von zwei Substraten besitzen. In den Behandlungskammern kann jeweils nur ein Substrat angeordnet werden.

Die Einfügung von zusätzlichen Wartekammern sowie die Kapazitätsvergrößerung der Einschleuse- und Ausschleusekammern erfordern vergleichsweise geringere Investitionen als die durch die Produktivitätssteigerung erzielbaren Erlöse ausmachen.

## Patentansprüche

1. Inline-Anlage zum Beschichten von einzelnen oder von Gruppen von Substraten (21, 22, 23, 24, 25, 26, 27), die mehrere hintereinander angeordnete, über Pumpen evakuierbare Kammern (E, W₁, W₂, B, B₁, B₂, B₃, A) aufweist, nämlich eine Einschleusekammer (E), eine Wartekammer (W₁), mindestens eine Prozesskammer (B, B₁, B₂, B₃), eine weitere Wartekammer (W₂) und eine Ausschleusekammer (A), die von den Substraten (21, 22, 23, 24, 25, 26, 27) oder Substratgruppen nacheinander durchlaufen werden und die durch Ventile jeweils verschließbar sind,
**dadurch gekennzeichnet, dass**
die Einschleuse- und die Ausschleusekammer (E, A) jeweils eine Kapazität zur gleichzeitigen Aufnahme von n hinter- oder nebeneinander angeordneten Substraten (21, 22, 23, 24, 25, 26, 27) oder Substratgruppen besitzen, wobei n eine natürliche Zahl größer als 1 ist, und dass die zwischen der Einschleusekammer (E) und der Prozesskammer (B, B₁, B₂, B₃) sowie zwischen der Ausschleusekammer (A) und der Prozesskammer (B, B₁, B₂, B₃) angeordnete Wartekammer (W₁, W₂) eine Kapazität zur Aufnahme von (n-1) Substrate (21, 22, 23, 24, 25, 26, 27) oder Substratgruppen besitzt, wohingegen die Kapazität der Behandlungskammern (B, B₁, B₂, B₃) jeweils auf die Aufnahme von einem Substrat (21, 22, 23, 24, 25, 26, 27) oder einer Substratgruppe beschränkt ist.

2. Inline-Anlage nach Anspruch 1, **dadurch gekennzeichnet, dass** die Einschleuse- und die Ausschleusekammer (E, A) n-mal so lang sind wie jede der Behandlungskammern (B, B₁, B₂, B₃).

3. Inline-Anlage nach Anspruch 1 oder 2, **dadurch gekennzeichnet, dass** als Prozesskammern (B, B₁, B₂, B₃) eine Ätzkammer (B₁) und eine, vorzugsweise zwei Beschichtungskammern (B₂, B₃) vorgesehen sind.

4. Inline-Anlage nach einem der Ansprüche 1 bis 3, **dadurch gekennzeichnet, dass** die Beschichtungskammern (B₂, B₃) eine PVD-Einrichtung aufweisen.

5. Verfahren zum Beschichten einzelner Substrate (21, 22, 23, 24, 25, 26, 27) oder Substratgruppen in einer Inline-Beschichtungsanlage nach einem der Ansprüche 1 bis 4,
**dadurch gekennzeichnet, dass**
zwischen jeweiligen Ätz- und/oder Beschichtungsbehandlungen die Substrate (21, 22, 23, 24, 25, 26, 27) oder Substratgruppen im Verbund von der Einschleusekammer (E) über die Wartekammer (W₁) in die Behandlungskammern (B, B₁, B₂, B₃) und eine weitere Wartekammer (W₂) in die Ausschleusekammer (A) so bewegt und behandelt werden, dass in aufeinanderfolgenden Schritten die Einschleusekammer (E) mit n Substraten (21, 22, 23, 24, 25, 26, 27) oder n Substratgruppen und jede der Behandlungskammern (B, B₁, B₂, B₃) mit jeweils nur einem Substrat (21, 22, 23, 24, 25, 26, 27) oder einer Substratgruppe belegt sind und die Wartekammern (W₁, W₂) frei von Substraten (21, 22, 23, 24, 25, 26, 27) oder Substratgruppen sind, anschließend die Substrate (21, 22, 23, 24, 25, 26, 27) oder Substratgruppen so weit vorwärts bewegt werden, dass ein aus jeder Behandlungskammer (B, B₁, B₂, B₃) ausgeschleustes Substrat (21, 22, 23, 24, 25, 26, 27) oder eine ausgeschleuste Substratgruppe durch ein nachgeführtes Substrat (21, 22, 23, 24, 25, 26, 27) oder eine nachgeführte Substratgruppe ersetzt wird und dass nach einer Teilbelegung der Wartekammer (W₁, W₂) die Belegung der Einschleusekammer (E) mit n Substraten (21, 22, 23, 24, 25, 26, 27) oder Substratgruppen vorgenommen wird, wonach sich die vorgehend beschriebene Abfolge der Substratbewegung und Kammerbelegung sukzessive wiederholt.

6. Verfahren nach Anspruch 5, **dadurch gekennzeichnet, dass** die Substrate (21, 22, 23, 24, 25, 26, 27) oder Substratgruppen vor der Beschichtung einem Ätzverfahren unterzogen werden.

7. Verfahren nach Anspruch 5 oder 6, **dadurch gekennzeichnet, dass** die Substrate (21, 22, 23, 24, 25, 26, 27) zweilagig beschichtet werden.

## Claims

1. In-line installation for coating individual substrates or groups of substrates (21, 22, 23, 24, 25, 26, 27), which has a plurality of chambers (E, W1, W2, B, B1, B2, 83, A) arranged one behind the other and evacuable by pumps, namely a load-lock chamber (E), a buffer chamber (W1), at least one process chamber (B, B1, B2, 83), a further buffer chamber (W2) and an unload-lock chamber (A), which are successively traversed by the substrates (21, 22, 23, 24, 25, 26, 27) or substrate groups and which can each be closed by valves,
**characterized in that**
the load-lock and the unload-lock chamber (E, A) in each case have a capacity for the simultaneous accommodation of n substrates (21, 22, 23, 24, 25, 26, 27) or substrate groups arranged one behind the other or next to one another, n being a natural number Z greater than 1, and that the buffer chamber (W1, W2) arranged between the load-lock chamber (E) and the process chamber (B, B1, B2, 83) and between the unload-lock chamber (A) and the process chamber (B, B1, B2, 83) has a capacity for receiving (n-1) substrates (21, 22, 23, 24, 25, 26, 27) or substrate groups, whereas the capacity of the treatment chambers (B, B1, B2, 83) is in each case restricted to receiving one substrate (21, 22, 23, 24, 25, 26, 27) or one substrate group.

2. In-line installation according to claim 1, **characterized in that** the load-lock and the unload-lock chamber (E, A) are n times as long as each of the treatment chambers (B, B1, B2, 83).

3. In-line installation according to claim 1 or 2, **characterized in that** as process chambers (B, B1, B2, 83) an etching chamber (B1) and one, preferably two coating chambers (B2, 83) are provided.

4. In-line installation according to any one of claims 1 to 3, **characterized in that** the coating chambers (B2, 83) have a PVD apparatus.

5. Method for coating individual substrates (21, 22, 23, 24, 25, 26, 27) or substrate groups in an in-line coating installation according to any one of claims 1 to 4,
**characterized in that**
between the respective etching and/or coating treatments the substrates (21, 22, 23, 24, 25, 26, 27) or substrate groups are moved and treated as a unit from the load-lock chamber (E) via the buffer chamber (W1) into the treatment chambers (B, B1, B2, 83) and a further buffer chamber (W2) into the unload-lock chamber (A) in such a way that in successive steps the load-lock chamber (E) is occupied with n substrates (21, 22, 23, 24, 25, 26, 27) or n substrate groups and each of the treatment chambers (B, B1, B2, 83) is occupied with in each case only one substrate (21, 22, 23, 24, 25, 26, 27) or one substrate group and the buffer chambers (W1, W2) are free of substrates (21, 22, 23, 24, 25, 26, 27) or substrate groups, then the substrates (21, 22, 23, 24, 25, 26, 27) or substrate groups are moved forward to such an extent that a substrate (21, 22, 23, 24, 25, 26, 27) or a substrate group discharged from each treatment chamber (B, B1, B2, 83) is replaced by a following substrate (21, 22, 23, 24, 25, 26, 27) or a following substrate group and that, after partial occupancy of the buffer chamber (W1, W2), the occupancy of the load-lock chamber (E) with n substrates (21, 22, 23, 24, 25, 26, 27) or substrate groups is carried out, after which the sequence of substrate movement and chamber occupancy described above is repeated successively.

6. Method according to claim 5, **characterized in that** the substrates (21, 22, 23, 24, 25, 26, 27) or substrate groups are subjected to an etching process prior to coating.

7. Method according to claim 5 or 6, **characterized in that** the substrates (21, 22, 23, 24, 25, 26, 27) are coated in two layers.

## Revendications

1. Installation en ligne pour le revêtement de substrats individuels ou de groupes de substrats (21, 22, 23, 24, 25, 26, 27), qui présente plusieurs chambres (E, W₁, W₂ , B, B₁,B₂ , B₃, A) disposées les unes derrière les autres et pouvant être mises sous vide à l'aide de pompes, à savoir une chambre d'entrée (E), une chambre d'attente (W₁ ), au moins une chambre de traitement (B, B₁,B₂ , B₃ ), une autre chambre d'attente (W₂ ) et une chambre de sortie (A), qui sont traversées successivement par les substrats (21, 22, 23, 24, 25, 26, 27) ou groupes de substrats et qui peuvent être fermées respectivement par des vannes,
**caractérisé en ce que**
les chambres d'entrée et de sortie (E, A) ont chacune une capacité permettant de recevoir simultanément n substrats disposés les uns derrière ou à côté les autres (21, 22, 23, 24, 25, 26, 27) ou de groupes de substrats, n étant un nombre naturel supérieur à 1, et **en ce que** la chambre d'attente (W₁, W₂) située entre la chambre d'introduction (E) et la chambre de traitement (B, B₁,B₂ , B₃ ) ainsi qu'entre la chambre de sortie (A) et la chambre de traitement (B, B₁, B₂, B₃ ) a une capacité permettant de recevoir (n-1) substrats (21, 22, 23, 24, 25, 26, 27) ou groupes de substrats, tandis que la capacité des chambres de traitement (B, B₁,B₂ , B₃ ) est limitée à la réception d'un substrat (21, 22, 23, 24, 25, 26, 27) ou d'un groupe de substrats.

2. Installation en ligne selon la revendication 1, **caractérisée en ce que** les chambres d'entrée et de sortie (E, A) sont n fois plus longues que chacune des chambres de traitement (B, B₁, B₂, B₃ ).

3. Installation en ligne selon la revendication 1 ou 2, **caractérisée en ce que** les chambres de traitement (B, B₁, B₂, B₃) sont une chambre de gravure (B₁) et une, de préférence deux chambres de revêtement (B₂ , B₃ ).

4. Installation en ligne selon l'une des revendications 1 à 3, **caractérisée en ce que** les chambres de revêtement (B₂ , B₃ ) comportent un dispositif PVD.

5. Procédé de revêtement de substrats individuels (21, 22, 23, 24, 25, 26, 27) ou de groupes de substrats dans une installation de revêtement en ligne selon l'une des revendications 1 à 4,
**caractérisé en ce que**
entre les traitements de gravure et/ou de revêtement respectifs, les substrats (21, 22, 23, 24, 25, 26, 27) ou groupes de substrats sont transférés - et traités - ensemble de la chambre d'introduction (E) vers la chambre d'attente (W₁) dans les chambres de traitement (B, B₁,B₂ , B₃ ) et une autre chambre d'attente (W₂ ) dans la chambre de sortie (A) de telle sorte que, par étapes successives, la chambre d'introduction (E) avec n substrats (21, 22, 23, 24, 25, 26, 27) ou n groupes de substrats et chacune des chambres de traitement (B, B₁,B₂, B₃) ne contiennent chacune qu'un seul substrat (21, 22, 23, 24, 25, 26, 27) ou un seul groupe de substrats, et que les chambres d'attente (W₁, W₂ ) ne contiennent aucun substrat (21, 22, 23, 24, 25, 26, 27) ou de groupes de substrats, puis les substrats (21, 22, 23, 24, 25, 26, 27) ou les groupes de substrats sont déplacés vers l'avant de telle sorte qu'un substrat (21, 22, 23, 24, 25, 26, 27) évacué de chaque chambre de traitement (B, B₁,B₂, B₃ ), ou un groupe de substrats évacué est remplacé par un substrat (21, 22, 23, 24, 25, 26, 27) ou un groupe de substrats (21, 22, 23, 24, 25, 26, 27) acheminé en aval, et qu'après un remplissage partiel de la chambre d'attente (W₁, W₂), le remplissage de la chambre d'introduction (E) avec n substrats (21, 22, 23, 24, 25, 26, 27) ou groupes de substrats est effectué, après quoi la séquence décrite précédemment du mouvement des substrats et du remplissage des chambres se répète successivement.

6. Procédé selon la revendication 5, **caractérisé en ce que** les substrats (21, 22, 23, 24, 25, 26, 27) ou groupes de substrats sont soumis à un procédé de gravure avant le revêtement.

7. Procédé selon la revendication 5 ou 6, **caractérisé en ce que** les substrats (21, 22, 23, 24, 25, 26, 27) sont revêtus de deux couches.
